(19) Europäisches Patentamt
European Patent Office
Office européen des brevets

(11) **EP 1 276 149 B1**

(12) **FASCICULE DE BREVET EUROPEEN**

(45) Date de publication et mention
de la délivrance du brevet:
**27.01.2010 Bulletin 2010/04**

(51) Int Cl.:
***H01L 23/367*** (2006.01)  ***H01L 29/737*** (2006.01)

(21) Numéro de dépôt: **02291698.5**

(22) Date de dépôt: **05.07.2002**

(54) **Composant électronique encapsulé comportant un dispositif électronique de puissance et procédé de fabrication**

Eingekapseltes elektronisches Bauelement mit elektronischer Leitungsvorrichtung und Herstellungsverfahren

Encapsulated electronic component including a power electronic device and method of making the same

(84) Etats contractants désignés:
**DE FR GB IT NL**

(30) Priorité: **13.07.2001 FR 0109407**

(43) Date de publication de la demande:
**15.01.2003 Bulletin 2003/03**

(73) Titulaire: **Thales**
**75008 Paris (FR)**

(72) Inventeurs:
• **Floriot, Didier,**
**Thales Intellectual Property**
**94117 Arcueil Cedex (FR)**
• **Caillas, Nicole,**
**Thales Intellectual Property**
**94117 Arcueil Cedex (FR)**
• **Delage, Sylvain,**
**Thales Intellectual Property**
**94117 Arcueil Cedex (FR)**
• **Jacquet, Jean-Claude,**
**Thales Intellectual Property**
**94117 Arcueil Cedex (FR)**

(74) Mandataire: **Esselin, Sophie**
**Marks & Clerk France**
**Conseils en Propriété Industrielle**
**Immeuble " Visium "**
**22, avenue Aristide Briand**
**94117 Arcueil Cedex (FR)**

(56) Documents cités:
**EP-A- 0 446 125   DE-A- 19 734 509**
**FR-A- 2 793 953   US-A- 5 306 948**
**US-A- 5 710 068   US-A- 5 734 193**

• **BAYRAKTAROGLU B ET AL: "Design and fabrication of thermally-stable AlGaAs/GaAs microwave power HBTs" PROCEEDINGS OF THE IEEE/CORNELL CONFERENCE ON ADVANCED CONCEPTS IN HIGH SPEED SEMICONDUCTOR DEVICES AND CIRCUITS. ITHACA, AUG. 2 - 4, 1993, NEW YORK, IEEE, US, 2 août 1993 (1993-08-02), pages 83-92, XP010109409 ISBN: 0-7803-0894-8**

**EP 1 276 149 B1**

**Description**

Le domaine de l'invention est celui des dispositifs électroniques de puissance, tels que des transistors bipolaires à hétéro jonction, utilisés pour des amplifications de puissance, en hyperfréquences.

Ces dispositifs électroniques fonctionnent généralement en impulsions longues d'une durée de plusieurs dizaines à plusieurs centaines de micro secondes, voire au-delà de la mille seconde, pour réaliser notamment des équipements de type radar de contrôle de trafic aérien.

Un des problèmes majeurs de ces composants demeure l'échauffement en fonctionnement, limitant la densité de puissance à quelques watt/mm.

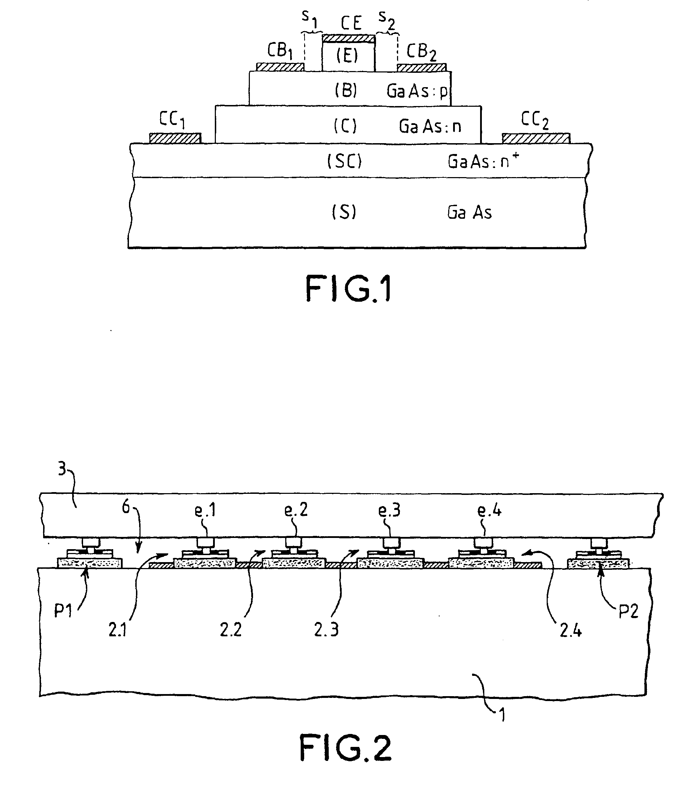

A ce jour plusieurs solutions ont été proposées pour réduire la résistance thermique du composant - la demanderesse a notamment déposé une demande de brevet publiée N° 2 793 953 - qui décrit l'utilisation d'un dissipateur thermique reposant à la fois sur le transistor et sur des piliers, le transistor et les piliers étant sur un même substrat semi-conducteur. En effet le transistor bipolaire à hétéro structure de matériau III-V fonctionne avec une injection de courant vertical. Il comprend de manière classique un émetteur, une base et un collecteur. La Figure 1 illustre un exemple de transistor bipolaire classique comportant par exemple :

- un substrat S semi-isolant en GaAs ;
- une couche de sous-collecteur SC en GaAs ou GAInP dopée n (concentration typiquement de l'ordre de $4.10^{18} m^{-3}$) ;
- une couche de collecteur C en GaAs dopée n ;
- une couche de base B en GaAs dopée p (concentration typiquement de l'ordre de $4.10^{19} m^{-3}$) ;
- une couche d'émetteur E en GaAs ou GaInP dopée n (concentration typiquement de l'ordre de $3.10^{17} m^{-3}$).

Sur la couche de sous-collecteur SC, sont réalisés des contacts de collecteur $CC_1$ et $CC_2$, sur la couche de base B sont réalisés des contacts de base $CB_1$ et $CB_2$, et sur la couche d'émetteur E, un contact d'émetteur CE.

Le transistor bipolaire de puissance hyperfréquence est constitué d'un grand nombre de cellules élémentaires décrites ci-dessus et montées en parallèle. Afin d'homogénéiser l'écoulement de la chaleur au travers du substrat, les émetteurs de quelques microns de largeur, typiquement deux microns sont séparés de quelques dizaines de microns, typiquement la trentaine de microns.

Quand un transistor à hétéro jonction fonctionne en impulsions longues (typiquement supérieures à 100 micro secondes), l'élévation de sa température pendant une impulsion peut être voisine ou supérieure à 100° C.

Il s'ensuit un certain nombre d'inconvénients :

- la puissance maximale autorisée est souvent limitée par la température atteinte pendant une impulsion plutôt que par la puissance moyenne à évacuer ;
- la puissance diminue quand la température s'élève ;
- la phase évolue quand la température s'élève.

La demande de brevet N° 2 793 953 propose d'utiliser un dissipateur thermique reposant à la surface de l'émetteur et sur des piliers $P_1$ et $P_2$ élaborés sur le substrat. La Figure 2 illustre le dissipateur thermique à la surface des transistors $e_1$, $e_2$, $e_3$, $e_4$. La chaleur est ainsi évacuée depuis le dissipateur thermique jusque dans le substrat porteur des empilements de couches.

Ainsi le dissipateur thermique remplit le rôle d'une capacité thermique sur les transistors bipolaires à hétéro jonction, pour absorber rapidement la quasi-totalité de la chaleur générée pendant une impulsion ; la chaleur après stockage pendant l'impulsion, peut ensuite être dissipée vers le substrat.

Avec cette configuration, on parvient à stabiliser ou minimiser la variation de température au cours d'une impulsion et à réduire la résistance thermique des transistors de puissance.

Une réduction de la résistance thermique par un facteur 2 peut typiquement être atteinte.

Cependant avec ce type de dissipateur thermique 3, utilisant la surface d'un substrat 1, il est nécessaire de posséder des surfaces de substrat d'autant plus grandes que la puissance à évacuer est importante. Ceci limite les capacités d'intégration de transistors de forte puissance et augmente par la même le coût de fabrication des amplificateurs de puissance.

Par ailleurs ces structures nécessitent d'être encapsulées comme tous les types de composants de cette nature pour assurer une protection aussi bien en terme d'usure, de pollution ou dégradation de propriétés physiques.

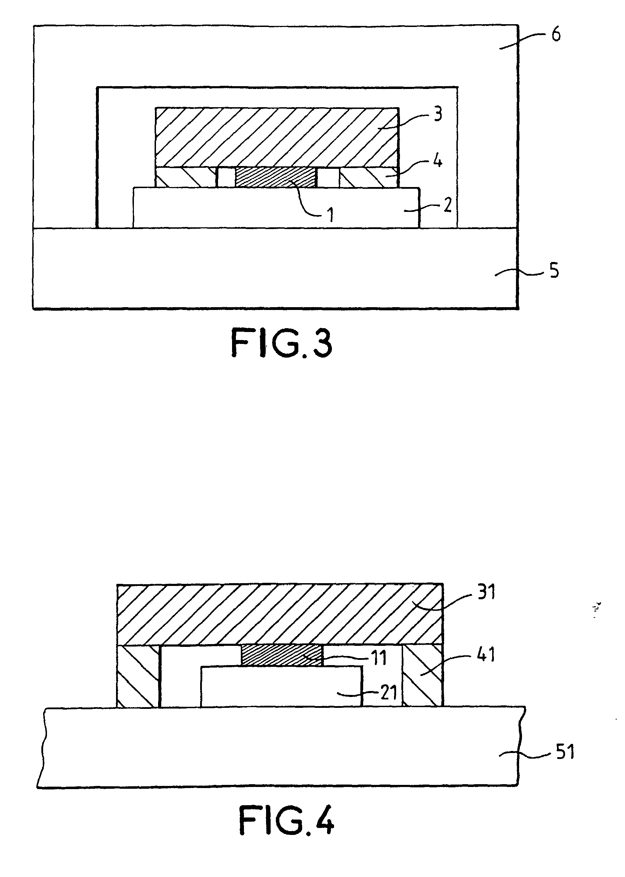

La Figure 3 illustre ainsi les transistors bipolaires 1 recouverts de leur drain thermique 3, à la surface d'un substrat 2 et reposant sur des piliers 4, ledit substrat étant positionné sur un support 5, équipé d'un capot de protection 6. Le substrat est ainsi protégé de l'ensemble des influences extérieures. Cette encapsulation classique nécessite cependant un espace disponible sur un support qui représente un frein à une intégration élevée.

Dans ce contexte la présente invention propose un composant encapsulé, dans lequel la couverture assurant

**2**

le transfert de chaleur assure également la fonction de micro encapsulation.

Plus précisément l'invention a pour objet un composant électronique encapsulé comportant un support porteur d'un substrat, ledit substrat comprenant un dispositif électronique de puissance, caractérisé en ce qu'il comporte un micro capot comprenant des piliers conducteurs thermiques positionnés sur le support, et un dissipateur thermique recouvrant la surface des piliers et la surface du dispositif électronique.

La solution d'écoulement du flux de chaleur se fait directement sans passer par des matériaux susceptibles d'apporter une contribution significative à la résistance thermique (tel que le GaAs, substrat de base couramment employé pour de tels composants) tout en conservant les avantages de l'invention décrite dans la publication de brevet 2 793 953, à savoir minimiser les variations de température sur la durée d'une impulsion.

Avantageusement le dispositif électronique de puissance est un transistor ou un ensemble de transistors de type barrette ou amplificateur, pouvant être de type transistor bipolaire à hétérojonction.

Selon des variantes de l'invention, le dissipateur thermique et/ou le support peuvent être en matériau bon conducteur thermique, par exemple de type métal.

Dans des variantes ou seulement l'un des deux éléments (dissipateur thermique) ou support est en métal, l'autre élément peut être en matériau diélectrique.

Selon une autre variante de l'invention, le composant encapsulé comprend en outre des moyens de circulation d'un fluide caloporteur, pouvant notamment être intégrés au sein du support, sous forme de micro canaux.

Le dispositif électronique de puissance étant encapsulé, le dissipateur thermique et/ou le support peuvent avantageusement comporter des vias pour connecter électriquement ledit dispositif électronique.

L'invention a aussi pour objet un composant électronique, caractérisé en ce qu'il comprend des brasures assurant le contact entre le dispositif électronique et le dissipateur thermique et/ou entre le substrat et le support.

Selon une variante de procédé, le dispositif électronique de puissance est recouvert d'une protection épaisse de type métal, permettant l'assemblage du dissipateur thermique à la surface du dispositif électronique de puissance par thermo-compression.

L'assemblage du dissipateur thermique, à la surface du dispositif électronique de puissance peut dans une autre variante de l'invention, être effectué au moyen d'une première brasure de soudure.

Avantageusement, le report dudit assemblage à la surface d'un support peut être effectué au moyen de secondes brasures de soudure.

De manière à ne pas altérer la première brasure, lors du report dudit assemblage sur le support par l'intermédiaire de secondes soudures, la température de fusion de la première brasure est supérieure à la température de fusion des secondes brasures.

L'invention sera mieux comprise et d'autres avantages apparaîtront à la lecture de la description qui va suivre, donnée à titre non limitatif et grâce aux figures annexées parmi lesquelles :

- la Figure 1 illustre un exemple de structure classique de transistor bipolaire ;
- la Figure 2 illustre une configuration de l'art antérieur, de dispositif électronique de type transistor bipolaire, comprenant un dissipateur thermique ;
- la Figure 3 illustre un exemple de composant encapsulé comprenant un dispositif électronique type transistor, de l'art antérieur ;
- la Figure 4 illustre une configuration de dispositif électronique encapsulé, selon l'invention ;
- les Figures 5a - 5c, illustrent un transistor bipolaire de l'art connu, renforcé par des pavés de résine et recouvert d'un film métallique selon différentes coupes ;
- la Figure 6 illustre une étape de procédé selon l'invention relative au report du dispositif électronique assemblé au dissipateur thermique, sur un support ;
- la Figure 7 illustre un exemple de composant encapsulé selon l'invention dans lequel le support comprend des moyens de circulation d'un fluide caloporteur ;
- la figure 8 illustre une variante de l'invention dans laquelle le support est métallique, le dissipateur thermique étant diélectrique ;
- la figure 9 illustre une variante de l'invention dans laquelle le support est diélectrique, le dissipateur thermique étant métallique ;
- la figure 10 illustre une variante de l'invention dans laquelle le support est constitué d'un bicouche diélectrique avec incorporation d'éléments métalliques, le dissipateur thermique étant métallique.

L'invention va être décrite dans le cadre des transistors à hétéro structure, mais peut s'appliquer à tout dispositif électronique de puissance pour lequel il est indispensable d'évacuer la chaleur emmagasinée.

De manière classique, les transistors bipolaires à hétéro structure à base de matériaux III-V, comprennent un empilement de couches semiconductrices, permettant une injection de courant vertical.

Typiquement le transistor peut être constitué de l'empilement suivant :

- couche de contact fortement dopée pour réaliser le contact ohmique supérieur ;
- couche(s) réalisant l'émetteur (pouvant être du semi-conducteur GaInP) pouvant intégrer une couche supplémentaire peu dopée en matériau GaAs afin d'intégrer une résistance. Dans le cas d'une structure épitaxiale inverse (transistor « collecteur-haut », il est possible de réaliser le collecteur comme décrit ci-après.
- couches réalisant le collecteur et l'émetteur (pouvant être du semi-conducteur Galnp ou GaAs) et comprenant une couche peu dopée et d'épaisseur suffisante afin d'obtenir une tension d'avalanche base-collecteur satisfaisante. La tension d'avalanche est la tension maximale que peut admettre la jonction base-collecteur polarisée en inverse avant création d'un courant d'avalanche généré par ionisation des atomes.
- couche de base (pouvant être du matériau GaAs) ;
- enfin, une couche de contact fortement dopée pour réaliser le contact ohmique inférieur.

Pour obtenir des dispositifs de puissance, on élabore de manière classique, des structures multi-doigts de transistors de puissance mis en parallèle qui génère un couplage thermique entre les doigts et la formation de points chauds nécessitant l'utilisation d'un drainage des calories approprié.

Typiquement, les transistors de puissance multi-doigts peuvent être au nombre de 10, pour des longueurs de doigts actifs comprises entre environ 10 et 150 $\mu$m.

Selon l'invention le drainage des calories est réalisé grâce à un pontage avec des pavés conducteurs disposés sur un support et un dissipateur thermique. La Figure 4 schématise le composant encapsulé de l'invention comportant, un support 51 sur lequel repose le substrat 21 porteur du dispositif électronique de puissance de type transistor 11, des piliers conducteurs 41, associés au dissipateur thermique 31 assurent l'évacuation de la chaleur, dans le support 51.

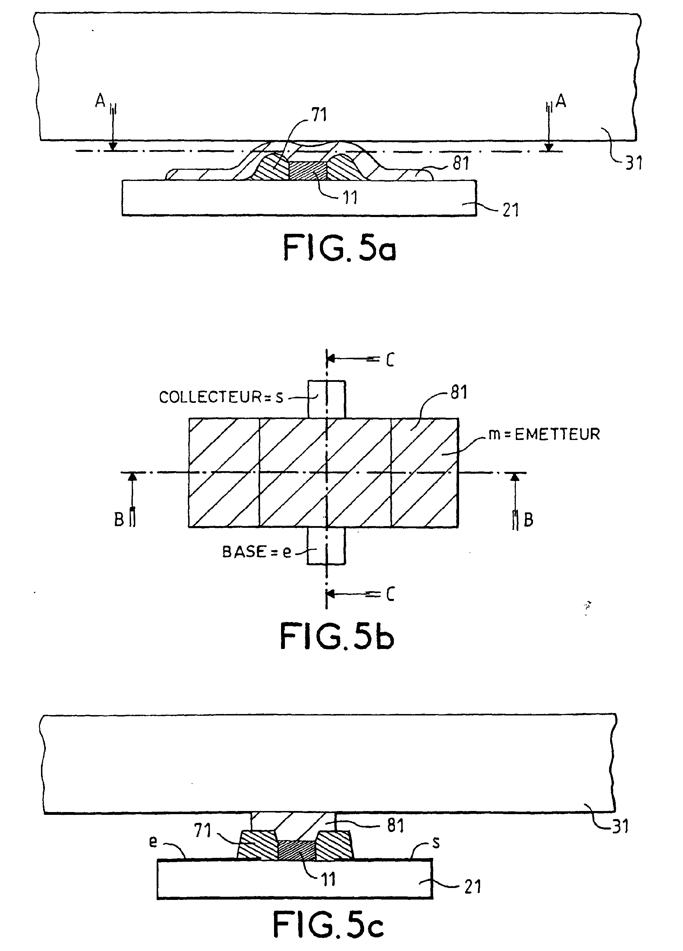

Les Figures 5a à 5c sont représentatives d'un zoom du transistor bipolaire 11, noyé dans de la résine 71 pour assurer la tenue mécanique, l'ensemble étant recouvert d'un film conducteur 81. Le dissipateur thermique 31 est en contact avec le film conducteur 81. Lors de l'étape d'assemblage dispositif de puissance / dissipateur thermique, le film conducteur 81 permet de réaliser l'étape de thermo-compression sans abîmer le dispositif de puissance.

La Figure 5b illustre une vue en coupe AA du transistor et du dissipateur thermique représentés en Figure 5a. L'entrée e correspond au contact de base, la sortie s correspond au contact de collecteur, et la masse m correspond au contact d'émetteur.

La Figure 5c illustre une vue en coupe CC du transistor et du dissipateur thermique.

Lorsque l'assemblage dissipateur / dispositif électronique de puissance est réalisé, on vient reporter ledit assemblage au niveau d'un support. Selon deux variantes possibles, soit les piliers conducteurs sont préalablement reportés sur le dissipateur thermique, soit sont reportés sur le support.

Dans des variantes de réalisation lorsque le dissipateur thermique est en métal ou le support est en métal, les piliers peuvent faire partie intégrante de l'élément en métal.

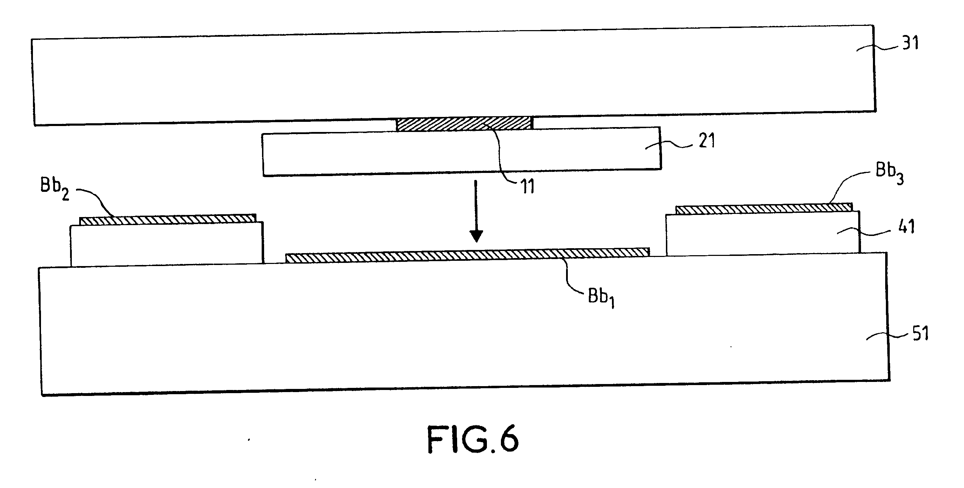

La Figure 6 illustre une étape de procédé de réalisation selon l'invention schématisant le report de l'assemblage préconstitué sur le support.

Ce support comprend des brasures dites basses températures $B_{b1}$, $B_{b2}$ et $B_{b3}$, ayant des températures de fusion plus basses que celle utilisée pour l'assemblage dissipateur thermique / dispositif de puissance. Les dépôts localisés de brasure basse température assurent une compensation de différences de hauteur et garantissent ainsi un contact simultané entre d'une part le fond du substrat et le support et d'autre part entre le dissipateur thermique et le support via les piliers de manière à constituer le composant encapsulé. Ces brasures basse température possèdent généralement un coefficient de dilatation élevée et permettent ainsi d'amortir des variations (cisaillement) mécaniques. L'apport de matière constitutive de la brasure, peut avantageusement être effectué par croissance électrolytique localisée qui autorise un contrôle de hauteur et un procédé collectif industriel. Typiquement les hauteurs de brasure basse température peuvent être de l'ordre de quelques dizaines de microns permettant de compenser dans un cas extrême des variations de hauteur du dispositif électronique de puissance ou des piliers.

Puisque les brasures haute température sont caractérisées par une bonne conductivité thermique, elles sont mises préférentiellement au plus près de la source de chaleur, afin de minimiser l'échauffement.

Avantageusement les piliers peuvent être des pavés métalliques bons conducteurs thermiques en cuivre par exemple. Ces pavés peuvent être réalisés par croissance électrolytique ou par assemblage de feuillet élémentaire.

Avantageusement le dissipateur thermique peut être en diamant, cuivre, argent, or etc... Le matériau constitutif du support est un matériau présentant une bonne conduction de la chaleur et possédant un coefficient d'expansion thermique compatible avec le matériau sur lequel est fabriqué le composant.

Il peut avantageusement s'agir d'un diélectrique de type $Al_2O_3$ ou AIN ou bien d'un métal de type Cu, CuW, Mo, AlSiC...

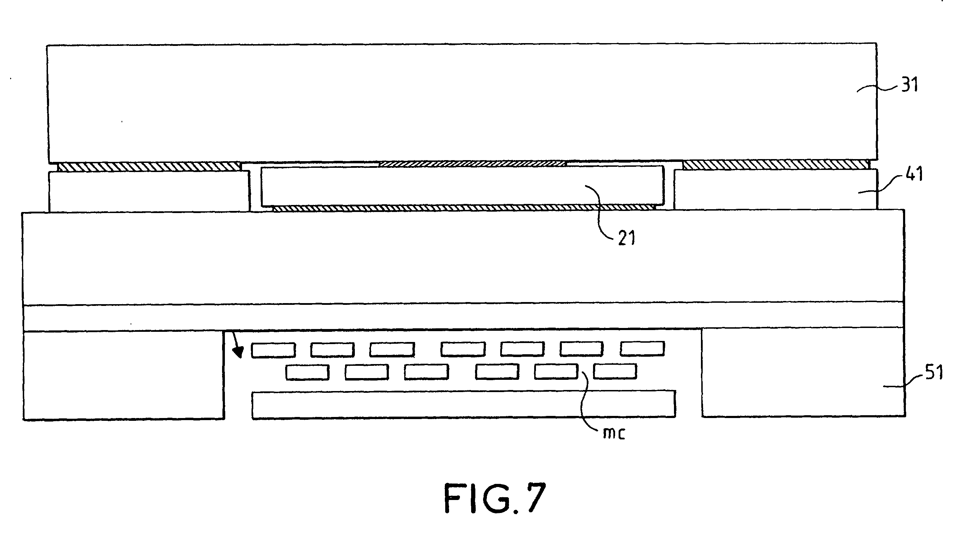

Avantageusement il peut être prévu une circulation d'un fluide caloporteur au sein du support comme l'illustre la Figure 7. Ainsi le support peut comprendre des micro canaux mC dans lesquels circule un fluide de refroidissement.

Selon une variante de l'invention, le support peut être réalisé par l'empilement de feuilles métalliques type cuivre, localement perforées, de manière à pouvoir faire circuler de l'eau à l'intérieur des canaux.

Selon l'invention, le dispositif électronique de puissance est ainsi encapsulé hermétiquement. Les opérations de brasure correspondent à des opérations de fermeture équivalente de boîtier pouvant être effectuées en atmosphère déshydrogénée.

Dans le composant encapsulé ainsi réalisé, le passage des signaux (continus et dynamiques) s'effectue avantageusement par l'intermédiaire de via métallisés réalisés dans le substrat du dispositif électronique de puissance ainsi que dans le dissipateur thermique ou dans le support, selon la nature dudit dissipateur thermique et celle du support.

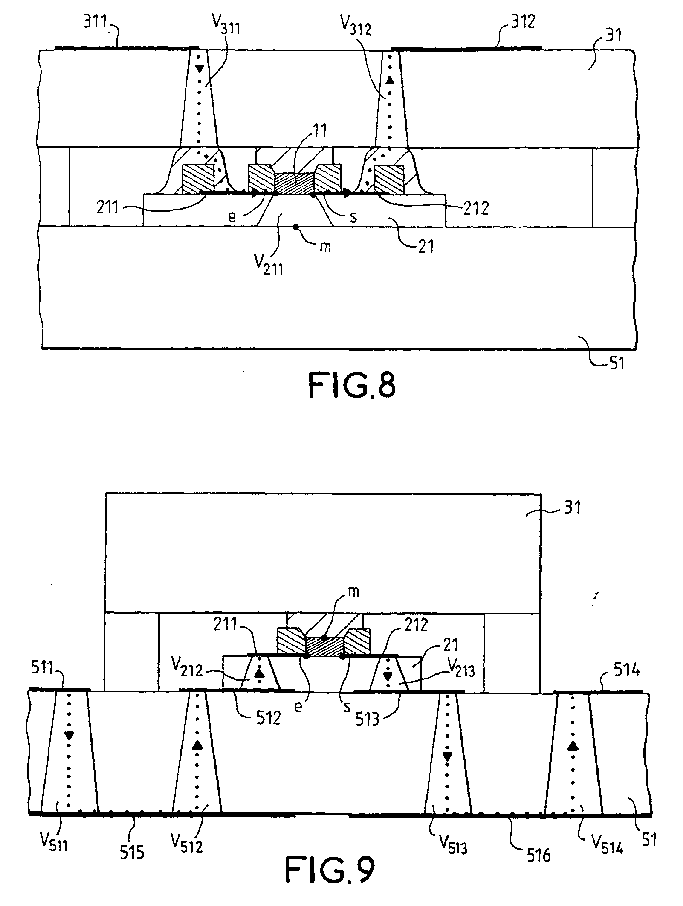

La Figure 8 illustre une variante de l'invention dans laquelle le support est métallique et le dissipateur thermique est diélectrique.

Les signaux électriques sont véhiculés depuis l'extérieur par des éléments métalliques 311, parcourent le dissipateur thermique 31, par des via conducteurs $V_{311}$ (les pointillés représentés en Figure 8 illustrent le parcours des signaux), pour se propager le long d'éléments conducteurs 211, jusqu'à un point d'entrée E du dispositif électronique de puissance 11. Le signal est ensuite récupéré en sortie S, se propage le long de l'élément conducteur 212, pour traverser le dissipateur thermique par le via conducteur 312, et être récupéré à l'extérieur par l'élément métallique 312. La masse M est quant à elle récupérée depuis le dispositif de puissance par l'intermédiaire d'un via métallique $V_{211}$ réalisé dans le substrat 21, et récupérée au niveau du support métallique 51.

La Figure 9 illustre une variante de l'invention dans laquelle, le support 51 est diélectrique, et le dissipateur thermique 31 est conducteur.

Les signaux électriques sont introduits dans le composant encapsulé au niveau du support 51, par l'intermédiaire d'éléments conducteurs 511, 515, 512 et de vias métalliques $V_{511}$, $V_{512}$ pour connecter l'entrée du dispositif électronique de puissance par l'intermédiaire d'un via $V_{212}$ et d'éléments conducteurs 211. La sortie S est récupérée au niveau d'un élément conducteur 212, d'un via métallique $V_{213}$ au travers du substrat, puis d'éléments conducteurs 513, 516 , 514 et de vias métalliques $V_{513}$ et $V_{514}$ au niveau du support 51. La masse M peut être directement récupérée au niveau du dissipateur thermique qui est conducteur dans cette variante de l'invention.

Selon une autre variante le support diélectrique peut être recouvert d'une couche métallique.

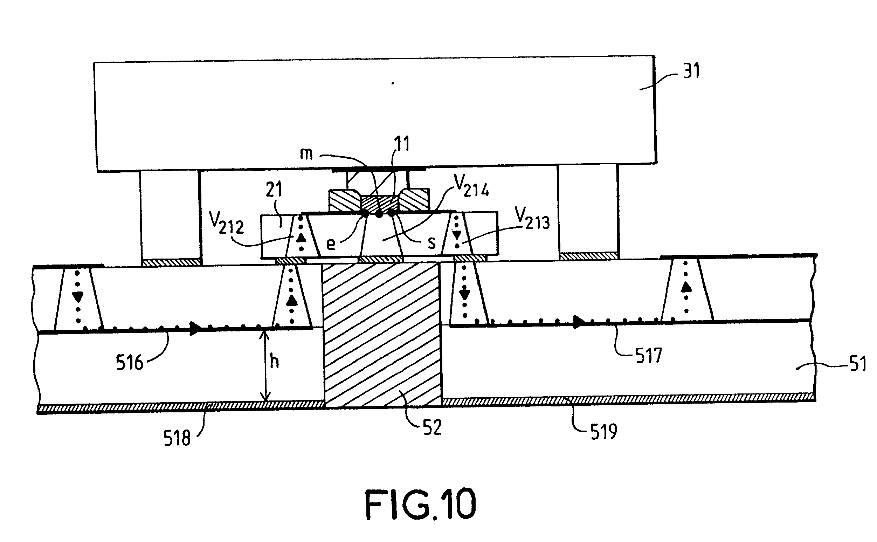

La Figure 10 illustre une variante proche de la variante illustrée précédemment, dans laquelle le support 51 est en matériau diélectrique avec incorporation d'éléments métalliques.

Le support 51 est une structure de bicouche diélectrique avec des pistes métalliques 516 et 517 insérées entre les deux couches. Typiquement, il peut s'agir d'alumine. L'ensemble est foré en son centre, on introduit dans l'inclusion 52 un métal, de manière à récupérer la masse au niveau du support. Les entrées et sorties du dispositif électronique sont connectées à l'extérieur de manière identique à celle décrite en Figure 9.

Le réglage de la hauteur h permet de varier la capacité équivalente $C : \frac{\in s}{h} (\in = \in o. \in r)$ S étant la surface métallique de ligne 516 ou 517 avec le plan de masse 518. En effet, il est plus intéressant d'avoir un matériau à forte $\in r$ que de l'air afin d'obtenir une valeur de capacité élevée.

La masse est récupérée par l'inclusion métallique 52 et des éléments conducteurs 518 et 519.

Les performances obtenues du composant selon l'invention ont été comparées à celles de composants de l'art antérieur, dans le cas d'un transistor de puissance comportant 40 doigts de 100 $\mu$m de long, la puissance dissipée dans chaque doigt étant de 576 mW, le substrat étant en GaAs de 70 $\mu$m d'épaisseur.

Le tableau ci-après fournit l'élévation de température maximale $\Delta T°max$ entre le point le plus chaud situé au centre d'un doigt de transistor au niveau du collecteur, et la température ambiante, ainsi que l'amélioration apportée sur la réduction de la résistance thermique, $R_{th}$.

Le cas a) concerne un transistor sans drain massif thermique, les cas b), c) et d) concernent des composants avec drain thermique supporté par le substrat et les cas e), f), g), h) concernent des composants selon l'invention dans lesquels le drain thermique repose au niveau du support.

Ce tableau met en évidence l'intérêt des solutions proposées dans l'invention pour évacuer au mieux la chaleur tout en conservant une solution intégrée d'encapsulation.

| | Drain thermique | Support | $\Delta T°max$ | Amélioration sur $R_{th}$ |
|---|---|---|---|---|
| (a) | aucun | CuW (400 $\mu$m) | 786 | 1 |
| (b) | diamant | Cu (60 $\mu$m) | 272 | 1,89 |
| (c) | Au | Cu (60 $\mu$m) | 332 | 1,37 |
| (d) | Au | Cu (60 $\mu$m) | 312 | 1,52 |
| (e) | diamant | Cu (70 $\mu$m) | 219 | 2,59 |
| (f) | diamant | Cu (70 $\mu$m) | 202 | 2,89 |

(suite)

| | Drain thermique | Support | $\Delta T°max$ | Amélioration sur $R_{th}$ |
|---|---|---|---|---|
| (g) | diamant | Cu (17 $\mu$m) sur AlN (127 $\mu$m) | 227 | 2,46 |
| (h) | diamant | Cu (70 $\mu$m) sur AlN (254 $\mu$m) | 214 | 2,67 |

**Revendications**

1. Composant électronique encapsulé comportant un support (51) porteur d'un substrat (21), ledit substrat comprenant un dispositif électronique de puissance (11), **caractérisé en ce qu'**il comporte un micro capot comprenant des piliers conducteurs thermiques (41) positionnés sur le support (51), et un dissipateur thermique (31) recouvrant la surface des piliers et la surface du dispositif électronique.

2. Composant électronique selon la revendication 1, **caractérisé en ce que** le dispositif électronique de puissance est un transistor ou un ensemble de transistors type barrette ou amplificateur.

3. Composant électronique selon la revendication 2, **caractérisé en ce que** le transistor est un transistor bipolaire à hétérojonction.

4. Composant électronique selon l'une des revendications 2 ou 3, **caractérisé en ce que** le dispositif électronique de puissance (11) est constitué d'un empilement de couches de matériaux III-V.

5. Composant électronique selon l'une des revendications 1 à 4, **caractérisé en ce que** le support (51) est un matériau diélectrique de type $Al_2O_3$ ou AlN.

6. Composant électronique selon la revendication 5, **caractérisé en ce que** le support (51) comprend une structure bicouche en matériau diélectrique avec incorporation d'éléments métalliques dans un plan situé à une profondeur h définie par rapport au plan inférieur extérieur dudit support.

7. Composant électronique selon la revendication 6, **caractérisé en ce qu'**il comporte en outre, une inclusion (52) en métal, sur l'ensemble de la hauteur du support (51).

8. Composant électronique selon l'une des revendications 1 à 4, **caractérisé en ce que** le support (51) est en matériau bon conducteur thermique ayant un coefficient d'expansion thermique compatible avec le substrat.

9. Composant électronique selon l'une des revendications 1 à 8, **caractérisé en ce qu'**il comprend en outre des moyens de circulation d'un fluide caloporteur intégrés au niveau du support.

10. Composant électronique selon la revendication 9, **caractérisé en ce que** le support est constitué d'un empilement de feuilles localement perforées.

11. Composant électronique selon la revendication 10, **caractérisé en ce que** les moyens de circulation sont des micro canaux.

12. Composant électronique selon l'une des revendications 1 à 11, **caractérisé en ce que** le dissipateur thermique et/ou le support comporte des vias pour connecter électriquement le dispositif électronique de puissance aux signaux d'entrée/sortie.

13. Composant électronique selon l'une des revendications 1 à 12, **caractérisé en ce qu'**il comprend des brasures assurant le contact entre le dispositif électronique et le dissipateur thermique et/ou entre le substrat et le support.

14. Procédé de fabrication de composant électronique encapsulé selon l'une des revendications 1 à 13, **caractérisé en ce qu'**il comprend les étapes suivantes :

    - la réalisation du dispositif électronique de puissance sur un substrat ;
    - l'assemblage du dissipateur thermique à la surface du dispositif électronique de puissance ;

- le report dudit assemblage à la surface d'un support, par l'intermédiaire de piliers conducteurs ;

**15.** Procédé de fabrication de composant électronique selon la revendication 14, **caractérisé en ce que** le dispositif électronique de puissance est recouvert d'une protection épaisse de type métal et **en ce que** l'assemblage du dissipateur thermique à la surface du dispositif électronique de puissance est effectué par thermocompression.

**16.** Procédé de fabrication de composant électronique selon la revendication 14, **caractérisé en ce que** l'assemblage du dissipateur thermique à la surface du dispositif électronique de puissance est effectué au moyen d'une première brasure de soudure.

**17.** Procédé de fabrication de composant électronique selon l'une des revendications 14 à 16, **caractérisé en ce que** le report dudit assemblage à la surface d'un support est effectué au moyen de secondes brasures de soudure.

**18.** Procédé de fabrication de composant électronique selon les revendications 16 et 17, **caractérisé en ce que** la température de fusion de la première brasure est supérieure à la température de fusion des secondes brasures.

**19.** Procédé de fabrication de composant électronique selon les revendications 16 à 17, **caractérisé en ce que** les opérations de brasures sont effectuées en atmosphère déshydrogénée.

## Claims

**1.** Encapsulated electronic component comprising a support (51) supporting a substrate (21), said substrate comprising a power electronic device (11), **characterized in that** it includes a micro-cover comprising heat-conducting posts (41) positioned on the support (51) and a heat dissipater (31) covering the surface of the posts and the surface of the electronic device.

**2.** Electronic component according to Claim 1, **characterized in that** the power electronic device is a transistor or a set of transistors of strip or amplifier type.

**3.** Electronic component according to Claim 2, **characterized in that** the transistor is a heterojunction bipolar transistor.

**4.** Electronic component according to one of Claims 2 and 3, **characterized in that** the power electronic device (11) consists of a stack of layers of materials III-V.

**5.** Electronic component according to one of Claims 1 to 4, **characterized in that** the support (51) is a dielectric material of $Al_2O_3$ or AlN type.

**6.** Electronic component according to Claim 5, **characterized in that** the support (51) comprises a bi-layer structure in dielectric material with the incorporation of metallic elements in a plane situated at a depth h defined relative to the external bottom plane of said support.

**7.** Electronic component according to Claim 6, **characterized in that** it also comprises a metal inclusion (52) over the entire height of the support (51).

**8.** Electronic component according to one of Claims 1 to 4, **characterized in that** the support (51) is made of a good heat-conducting material having a thermal expansion coefficient compatible with the substrate.

**9.** Electronic component according to one of Claims 1 to 8, **characterized in that** it also comprises means of circulating coolant that are integrated at the level of the support.

**10.** Electronic component according to Claim 9, **characterized in that** the support consists of a stack of locally perforated sheets.

**11.** Electronic component according to Claim 10, **characterized in that** the circulation means are microchannels.

**12.** Electronic component according to one of Claims 1 to 11, **characterized in that** the heat dissipator and/or the support includes vias for electrically connecting the power electronic device to the input/output signals.

13. Electronic component according to one of Claims 1 to 12, **characterized in that** it comprises solder joints ensuring the contact between the electronic device and the heat dissipator and/or between the substrate and the support.

14. Method of fabricating encapsulated electronic components according to one of Claims 1 to 13, **characterized in that** it comprises the following steps:

- production of the power electronic device on a substrate;
- assembly of the heat dissipator on the surface of the power electronic device;
- the mounting of said assembly on the surface of a support, via conductive posts.

15. Method of fabricating electronic components according to Claim 14, **characterized in that** the power electronic device is covered by a thick metal-type protection and **in that** the assembly of the heat dissipator on the surface of the power electronic device is performed by thermocompression.

16. Method of fabricating electronic components according to Claim 14, **characterized in that** the assembly of the heat dissipator on the surface of the power electronic device is performed by means of a first solder joint.

17. Method of fabricating electronic components according to one of Claims 14 to 16, **characterized in that** the mounting of said assembly on the surface of a support is performed by means of second solder joints.

18. Method of manufacturing electronic components according to Claims 16 and 17, **characterized in that** the melting point of the first solder joint is greater than the melting point of the second solder joints.

19. Method of fabricating electronic components according to Claims 16 and 17, **characterized in that** the soldering operations are performed in a dehydrogenated atmosphere.


**Patentansprüche**

1. Verkapseltes elektronisches Bauteil, das einen ein Substrat (21) tragenden Träger (51) aufweist, wobei das Substrat eine elektronische Leistungsvorrichtung (11) enthält, **dadurch gekennzeichnet, dass** es eine Mikroabdeckung aufweist, die auf dem Träger (51) positionierte wärmeleitende Säulen (41) und einen Wärmeableiter (31) enthält, der die Fläche der Säulen und die Fläche der elektronischen Vorrichtung bedeckt.

2. Elektronisches Bauteil nach Anspruch 1, **dadurch gekennzeichnet, dass** die elektronische Leistungsvorrichtung ein Transistor oder eine Gruppe von Transistoren vom Typ Stab oder Verstärker ist.

3. Elektronisches Bauteil nach Anspruch 2, **dadurch gekennzeichnet, dass** der Transistor ein Bipolartransistor mit Heteroübergang ist.

4. Elektronisches Bauteil nach einem der Ansprüche 2 oder 3, **dadurch gekennzeichnet, dass** die elektronische Leistungsvorrichtung (11) aus einer Stapelung von Schichten aus III-V-Materialien besteht.

5. Elektronisches Bauteil nach einem der Ansprüche 1 bis 4, **dadurch gekennzeichnet, dass** der Träger (51) ein dielektrisches Material vom Typ $Al_2O_3$ oder AlN ist.

6. Elektronisches Bauteil nach Anspruch 5, **dadurch gekennzeichnet, dass** der Träger (51) einen Zweischichtenaufbau aus dielektrischem Material mit Einfügung von Metallelementen in einer Ebene enthält, die sich in einer Tiefe h befindet, die bezüglich der unteren äußeren Ebene des Trägers definiert ist.

7. Elektronisches Bauteil nach Anspruch 6, **dadurch gekennzeichnet, dass** es außerdem einen Einschluss (52) aus Metall über die ganze Höhe des Trägers (51) aufweist.

8. Elektronisches Bauteil nach einem der Ansprüche 1 bis 4, **dadurch gekennzeichnet, dass** der Träger (51) ein gut wärmeleitendes Material ist, das einen mit dem Substrat kompatiblen Wärmeausdehnungskoeffizient hat.

9. Elektronisches Bauteil nach einem der Ansprüche 1 bis 8, **dadurch gekennzeichnet, dass** es außerdem Einrichtungen für die Zirkulation eines Wärmeträgerfluids enthält, die in Höhe des Trägers integriert sind.

**10.** Elektronisches Bauteil nach Anspruch 9, **dadurch gekennzeichnet, dass** der Träger aus einer Stapelung von stellenweise gelochten Folien besteht.

**11.** Elektronisches Bauteil nach Anspruch 10, **dadurch gekennzeichnet, dass** die Zirkulationseinrichtungen Mikrokanäle sind.

**12.** Elektronisches Bauteil nach einem der Ansprüche 1 bis 11, **dadurch gekennzeichnet, dass** der Wärmeableiter und/oder der Träger Lücken aufweisen, um die elektronische Leistungsvorrichtung elektrisch mit den Eingangs/ Ausgangssignalen zu verbinden.

**13.** Elektronisches Bauteil nach einem der Ansprüche 1 bis 12, **dadurch gekennzeichnet, dass** es Lötstellen enthält, die den Kontakt zwischen der elektronischen Vorrichtung und dem Wärmeableiter und/oder zwischen dem Substrat und dem Träger gewährleisten.

**14.** Verfahren zur Herstellung eines verkapselten elektronischen Bauteils nach einem der Ansprüche 1 bis 13, **dadurch gekennzeichnet, dass** es die folgenden Schritte aufweist:

- Herstellung der elektronischen Leistungsvorrichtung auf einem Substrat;
- Montage des Wärmeableiters auf die Oberfläche der elektronischen Leistungsvorrichtung;
- Übertragung der Anordnung auf die Oberfläche eines Trägers mittels leitender Säulen.

**15.** Verfahren zur Herstellung eines elektronischen Bauteils nach Anspruch 14, **dadurch gekennzeichnet, dass** die elektronische Leistungsvorrichtung mit einem dicken Schutz vom Typ Metall bedeckt ist, und dass die Montage des Wärmeableiters auf die Oberfläche der elektronischen Leistungsvorrichtung durch Thermokompression erfolgt.

**16.** Verfahren zur Herstellung eines elektronischen Bauteils nach Anspruch 14, **dadurch gekennzeichnet, dass** die Montage des Wärmeableiters auf die Oberfläche der elektronischen Leistungsvorrichtung mittels einer ersten Schweißlötstelle erfolgt.

**17.** Verfahren zur Herstellung eines elektronischen Bauteils nach einem der Ansprüche 14 bis 16, **dadurch gekennzeichnet, dass** die Übertragung der Anordnung auf die Oberfläche einer Träger mittels zweiter Schweißlötstellen erfolgt.

**18.** Verfahren zur Herstellung eines elektronischen Bauteils nach einem der Ansprüche 16 und 17, **dadurch gekennzeichnet, dass** die Schmelztemperatur der ersten Lötstelle höher als die Schmelztemperatur der zweiten Lötstellen ist.

**19.** Verfahren zur Herstellung eines elektronischen Bauteils nach den Ansprüchen 16 bis 17, **dadurch gekennzeichnet, dass** die Lötvorgänge unter wasserstofffreier Atmosphäre durchgeführt werden.

FIG.1

FIG.2

FIG.3

FIG.4

FIG.5a

COLLECTEUR = s

BASE = e

m = EMETTEUR

FIG.5b

FIG.5c

FIG.6

EP 1 276 149 B1

FIG.7

EP 1 276 149 B1

FIG.8

FIG.9

FIG.10

**RÉFÉRENCES CITÉES DANS LA DESCRIPTION**

**Documents brevets cités dans la description**

- US 2793953 A